# EUROPEAN PATENT SPECIFICATION

(11) **EP 2 336 671 B1**
(45) Date of publication and mention of the grant of the patent: **11.06.2014**
(21) Application number: 10188898.0
(22) Date of filing: 26.10.2010
(51) Int. Cl.: H01L 31/052, F24J 2/10, F24J 2/18

(54) **Linear concentrating solar collector with decentered trough-type reflectors**
Sonnenkollektor mit linearer Konzentration mit dezentriertem trogförmigem Reflektor
Collecteur solaire à concentration linéaire avec réflecteurs de type décentré

(30) Priority: 03.11.2009 US 611789
(43) Date of publication of application: 22.06.2011
(73) Proprietor: Palo Alto Research Center Incorporated, Palo Alto, California 94304 (US)
(72) Inventor: Maeda, Patrick Y, Mountain View, CA 94040 (US)
(74) Representative: Skone James, Robert Edmund

(56) References cited:
- WO-A1-2011/044641
- US-A1- 2006 249 143
- US-A1- 2009 056 698

## Description

This invention relates to solar power generators, more particularly to concentrating solar collectors.

Photovoltaic solar energy collection devices used to generate electric power generally include flat-panel collectors and concentrating solar collectors. Flat collectors generally include photovoltaic cell arrays and associated electronics formed on semiconductor (e.g., monocrystalline silicon or polycrystalline silicon) substrates, and the electrical energy output from flat collectors is a direct function of the area of the array, thereby requiring large, expensive semiconductor substrates. Concentrating solar collectors reduce the need for large semiconductor substrates by concentrating light beams (i.e., sun rays) using, e.g., a parabolic reflectors or lenses that focus the beams, creating a more intense beam of solar energy that is directed onto a small photovoltaic cell. Thus, concentrating solar collectors have an advantage over flat-panel collectors in that they utilize substantially smaller amounts of semiconductor.

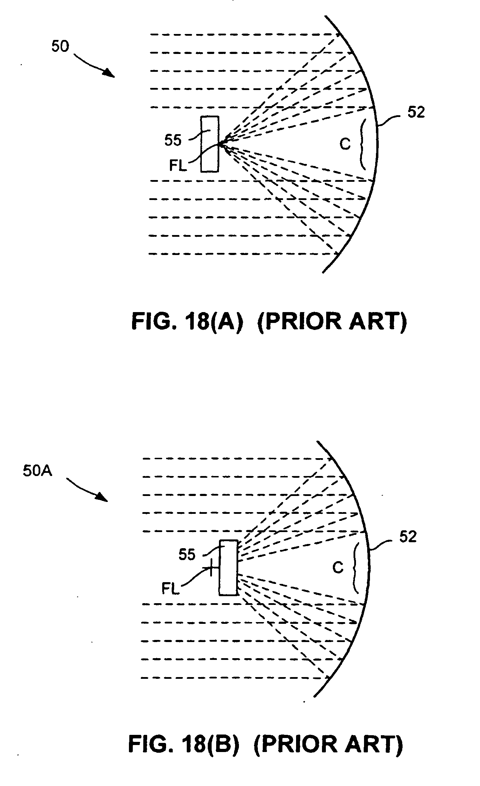

Fig. 18(A) shows a conventional linear (e.g., trough-type) concentrating solar collector 50 including a curved (e.g., cylindrical parabolic) reflector 52 that focuses light onto on a focal line FL (i.e., extending into the plane of the figure), and a linearly arranged photovoltaic (PV) solar cell 55 that is disposed on focal line FL. Solar radiation (sunlight) directed onto curved reflector 52 is indicated in Fig. 18(A) by dashed lines, which show that the incoming sunlight is reflected and concentrated by curved reflector 52. A problem with conventional linear concentrating solar collector 50 is that, because reflective surface 52 is curved in one direction only, the light distribution of the concentrated sunlight produced by reflective surface 52 is focused on PV cell 55, creating a highly peaked irradiance distribution on PV cell 55 having a local concentration of 300 suns, which causes high I²R series resistance and associated losses in solar cell 55 due to high current density levels. As indicated by modified conventional linear concentrating solar collector 50A in Fig. 18(B), one approach for reducing the highly peaked irradiance distribution is to defocus the system by moving the position of solar cell 55 inside the system focal plane (i.e., between focal line FL and reflective surface 52) . This approach spreads the sunlight out over the surface of solar cell 55, but the light distribution on solar cell 55 is still highly peaked.

Another problem with conventional linear concentrating solar collectors is that they are expensive to produce, operate and maintain. The reflectors and/or lenses used in conventional collectors to focus the light beams are produced separately, and must be painstakingly assembled to provide the proper alignment between the focused beam and the photovoltaic cell. Further, over time, the reflectors and/or lenses can become misaligned due to thermal cycling or vibration, and become dirty due to exposure to the environment. Maintenance in the form of cleaning and adjusting the reflectors/lenses can be significant, particularly when the reflectors/lenses are produced with uneven shapes that are difficult to clean.

Yet another problem associated with conventional concentrating solar collectors is that they typically include at least structure (e.g., a PV cell or mirror) that is disposed over the light receiving surface and creates a shading effect, which in turn reduces the peak power output that can be obtained by conventional concentrating solar collectors. For example, PV cell 55, shown in Figs. 18(A) and 18(B), shades a central region C of reflector 52.

US-A-20090056698 discloses a solar energy collector suitable for use in a solar energy collection system that tracks movements of the sun along at least one axis may have a plurality of reflector panels, a support structure that supports the reflector panels in a manner that defines a pair of adjacent reflector troughs, each trough having a base, a pair of reflective side walls and a trough aperture suitable for receiving incident sunlight during operation of the solar energy collection system, a frame that is coupled to the support structure near the bases of the troughs to define a closed reflector support truss framework in cooperation with the support structure, wherein the reflector support truss framework is positioned behind the reflector troughs such that the reflector support truss framework does not shadow the reflector panels during normal operation of the solar energy collector,; and a plurality of solar receivers.

WO-A-2011/044641 describes a reflector to reflect solar radiation, the reflector having a reflector surface, the surface being concave, and wherein the surface curves about a first axis and a second axis, the second axis being in a plane generally normal to the first axis and curved about the first axis; and an apparatus for collection and utilization of solar energy comprising at least one of the reflectors, and at least one photovoltaic cell associated with each surface and positioned relative to the associated surface so as to be positioned to receive radiation reflected by the associated surface and to convert the radiation to electrical energy, the apparatus further comprising heat conversion means for converting excess solar radiation energy incident thereon to heat energy.

What is needed is a concentrating solar collector that avoids the highly peaked irradiation distribution, shading issue, and expensive assembly and maintenance costs associated with conventional concentrating solar collectors.

In accordance with the present invention, a linear concentrating solar collector comprises:
at least one solar energy collection element;
a first trough-type reflector having a first curved reflective surface defining a first focal line; and
a second trough-type reflector having a second reflective surface defining a second focal line,
wherein the first trough-type reflector and the second trough-type reflector are fixedly connected along a common edge in a decentered arrangement in which the first focal line is parallel to and spaced-apart from the second focal line, and said first and second curved reflective surfaces are arranged such that first solar radiation directed onto said first curved reflective surface is reflected and concentrated by said first curved reflective surfaces toward the first focal line, and second solar radiation directed onto said second curved reflective surface is reflected and concentrated by said second curved reflective surfaces toward the second focal line, said reflected first and second solar radiation is respectively directed by the first and second curved reflective surfaces such that said first and second solar radiation overlap in a defocused state , and
wherein the at least one solar energy collection element is fixedly connected to the first and second trough-type reflectors and positioned to operably receive at least one of the reflected first and second solar radiation, and is characterized in that the collector further comprises a solid, light-transparent optical structure having a substantially flat front surface and an opposing rear surface, the rear surface including a first reflective surface region and a second reflective surface region,
wherein the first and second trough-type reflectors are respectively disposed on the first and second reflective surface regions such that the first and second curved reflective surfaces face into the optical structure, wherein the first and second trough-type reflectors preferably comprise one of metal films and high efficiency multilayer dielectric reflective coatings deposited directly onto the first and second reflective surface regions, respectively.

The present invention is directed to a linear concentrating solar collector including two trough-type reflectors having curved reflective surfaces defining respective first and second focal lines, wherein the trough reflectors are fixedly connected along a common edge in a decentered arrangement in which the first and second focal lines are parallel and spaced-apart, and the curved reflective surfaces are arranged such that solar radiation is reflected and concentrated toward the first and second focal lines in a way that causes the reflected solar radiation to overlap (i.e., cross paths) while in a defocused state, and wherein at least one solar energy collection element (solar cell) is positioned to receive defocused solar radiation reflected from at least one of the trough-type reflectors. The decentered reflective surfaces (e.g., off-axis cylindrical parabolic, conics, aspherics, etc.) combine to form an optical system that concentrates the solar radiation such that the light is spread out in a more uniform irradiance distribution on the solar cell in order to lower the peak local concentration, which reduces the I²R series resistance associated losses due to smaller current density levels. In this way, the optical system utilized in the present invention reduces the peak concentration on the solar cell by a factor of approximately 20 relative to a conventional focused system, and by a factor of approximately 2.3 relative to a conventional defocused system without requiring a secondary optical element. The optical system employed by the present invention also produces a substantially more uniform irradiance distribution relative to designs that use a centered surface.

According to an embodiment of the present invention the solar cell is positioned in an overlap region between the decentered reflectors and the first and second focal lines such that the solar cell receives solar radiation reflected from both of the decentered reflective surfaces. This arrangement minimizes the size of the solar cell while taking advantage of maximum uniform irradiance provided by the combined overlapping light. In one specific embodiment, a solid, light-transparent optical structure having a substantially flat front surface and an opposing rear surface is utilized to support both the solar cell (on the front surface) and the trough-like reflectors (on the rear surface) such that the decentered reflective surfaces and solar cell both face into and are separated by the light-transparent optical structure. Because the optical structure is solid (i.e., because the front and rear surfaces remain fixed relative to each other), the decentered reflective surfaces and solar cell remain permanently aligned and properly spaced, thus maintaining optimal optical operation while minimizing maintenance costs. Moreover, the loss of light at gas/solid interfaces is minimized because only solid optical structure material (e.g., low-iron glass) is positioned between the decentered reflective surfaces and the PV cells. In accordance with a specific embodiment, the reflective surface regions of the rear surface are processed to include decentered surface shapes, and the decentered reflective surfaces are formed by a reflective mirror material (e.g., silver, aluminum or other suitable reflective metal, or high efficiency multilayer dielectric reflective coating) film that is directly formed (e.g., deposited or plated) onto the decentered surface shapes. By carefully processing the decentered surface shapes on the optical structure, the decentered reflective surfaces are essentially self-forming and self-aligned when formed as a mirror material film, thus greatly simplifying the manufacturing process and minimizing production costs.

According to another specific embodiment, a linear concentrating solar collector includes a solid, light-transparent optical structure having a substantially flat front surface and an opposing rear surface including two receiver surface regions disposed on opposite sides of two reflective surface regions. Similar to the previous embodiment, the two reflective surface regions are provided with decentered (e.g., off-axis conic) surface shapes, and trough-like reflectors are disposed on the reflective surface regions, e.g., by applying a reflective mirror material as a mirror material film that forms decentered reflective surfaces. However, the present embodiment differs from earlier embodiments in that the receiver surfaces regions (on which the solar cells are mounted) and the reflective surface regions (on which the decentered reflective surfaces are formed) collectively make up the entire rear surface such that all of the solar radiation passing through the front surface either directly strikes one of the solar cells, or is reflected and concentrated by the decentered reflective surfaces onto the solar cells. In addition, the two decentered reflective surfaces are shaped such that sunlight is reflected toward the front surface of the optical element at an angle that produces total internal reflection (TIR) of the sunlight from the front surface, and directs the re-reflected sunlight onto one of the solar cells in a defocused state. With this arrangement, substantially all solar radiation entering the optical element is either directed onto the solar cells, or reflected by the decentered reflective surfaces and total internal reflected by the front surface onto the solar cells, thereby providing a highly efficient concentrating solar collector having no shaded regions. A single decentered reflective surface and a side reflector can be combined and mounted on the outer side of the solar cells to collect the light from two decentered reflective surfaces, which increases the efficiency of the system, and also provides a substantially uniform irradiance distribution on the solar cells.

According to another specific of the present invention, the concentrating solar collector 100 includes three solar cells and four trough-like reflectors arranged to form two pairs of decentered reflective surfaces that are disposed in an interleaved pattern on the rear surface of the solid optical structure. Each pair of decentered reflective surfaces are arranged to reflect light to the two solar cells disposed on opposite outside edges of their associated trough-like reflectors, with the central solar cell receiving reflected radiation from both pairs of decentered reflective surfaces. A single decentered reflective surface and a side reflector can be combined and mounted on the outer side of the outer most solar cells to collect the same amount of light as the center cell. This configuration increases the light collection efficiency of the system, and also provides a substantially uniform irradiance distribution on the solar cells.

These and other features, aspects and advantages of the present invention will become better understood with regard to the following description, appended claims, and accompanying drawings, where:
Fig. 1 is a perspective view showing a linear concentrating solar collector according toa comparative example;
Fig. 2 is a simplified diagram showing a decentered curved reflector arrangement utilized by the linear concentrating solar collector of Fig. 1;
Fig. 3(A) is a graph depicting the highly peaked irradiance distribution generated by the conventional concentrating solar collector of Fig. 18B;
Fig. 3(B) is a graph depicting a more uniform irradiance distribution generated by the concentrating solar collector of Fig. 1;
Fig. 4 is a simplified side view showing the linear concentrating solar collector of Fig. 1 during operation;
Fig. 5 is an exploded perspective view showing a linear concentrating solar collector according to a first embodiment of the present invention;
Fig. 6 is an assembled perspective view showing the linear concentrating solar collector of Fig. 5;
Fig. 7 is a simplified side view showing the linear concentrating solar collector of Fig. 5 during operation;
Fig. 8 is an exploded perspective view showing a linear concentrating solar collector according to another embodiment of the present invention;
Fig. 9 is an assembled perspective view showing the linear concentrating solar collector of Fig. 8;
Fig. 10 is a simplified side view showing the linear concentrating solar collector of Fig. 8 during operation;
Fig. 11 is a perspective view showing a linear concentrating solar collector according to another embodiment of the present invention;
Fig. 12 is a perspective view showing a linear concentrating solar collector according to another embodiment of the present invention;
Fig. 13 is a simplified side view showing the linear concentrating solar collector of Fig. 12 during operation;
Fig. 14 is a simplified perspective view showing a linear concentrating solar collector with side reflectors and additional outer decentered reflective surfaces according to another embodiment of the present invention;
Fig. 15 is a simplified cross-sectional view showing the linear concentrating solar collector of Fig. 14 during operation;
Figs. 16(A) and 16(B) are perspective views showing optical structures for concentrating solar collectors according to alternative embodiments of the present invention;
Fig. 17 is a simplified cross-sectional view showing the linear concentrating solar collector with side reflectors according to another embodiment of the present invention; and
Figs. 18(A) and 18(B) are simplified side views showing conventional linear concentrating solar collector arrangements

The present invention relates to an improvement in concentrating solar collectors. The following description is presented to enable one of ordinary skill in the art to make and use the invention as provided in the context of a particular application and its requirements. As used herein, directional terms such as "front", "rear", "side", "over", "under", "right", "left", "rightward", "leftward", "upper", "lower", "above" and "below" are intended to provide relative positions for purposes of description, and are not intended to designate an absolute frame of reference. In addition, the phrase "solid, single-piece" is used herein to describe a singular molded or machined structure, as distinguished from multiple structures that are produced separately and then joined by way of, for example, adhesive, fastener, clip, or movable joint. Various modifications to the preferred embodiment will be apparent to those with skill in the art, and the general principles defined herein may be applied to other embodiments. Therefore, the present invention is not intended to be limited to the particular embodiments shown and described, but is to be accorded the widest scope consistent with the principles and novel features herein disclosed.

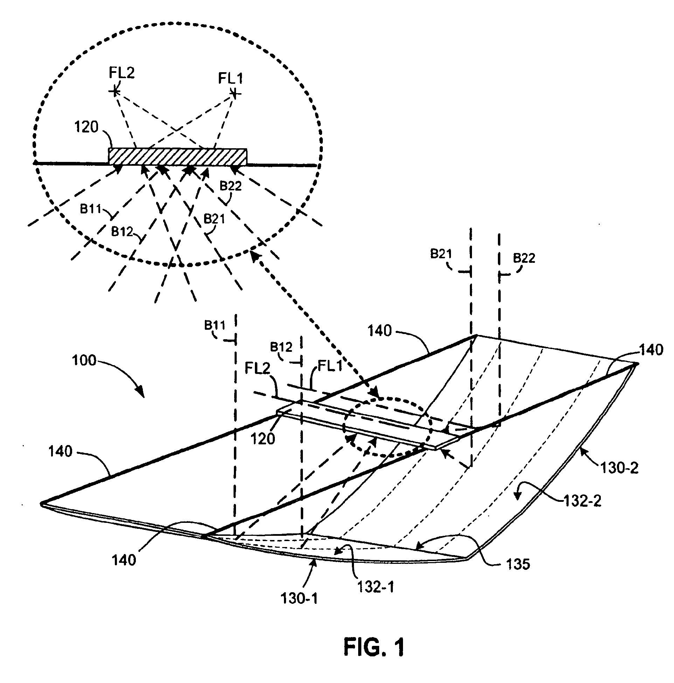

Fig. 1 shows a portion of a linear concentrating solar collector 100 including a linear photovoltaic (PV) cell (solar energy collection element) 120, first and second trough-type reflectors 130-1 and 130-2 disposed under PV cell 120, and a set of supporting rods 140 that serve to fixedly support PV cell 120 over trough-type reflectors 130-1 and 130-2. During operation, concentrating solar collector 100 is oriented using known techniques such that solar radiation (sunlight) is directed substantially perpendicularly through front surface 112 into optical structure 110, as indicated by the dashed line arrows B11, B12, B21 and B22.

As indicated in Fig. 1, PV cell 120 is secured to trough-type reflectors 130-1 and 130-2 using supporting rods 140 with its active surface facing trough-type reflectors 130-1 and 130-2 and positioned such that, as indicated by dashed-lined arrows B11, B12, B21 and B22, solar radiation directed toward trough-type reflectors 130-1 and 130-2 is reflected onto the active surface of PV cell 120. PV cell 120 has a substantially rectangular and elongated shape, and is preferably designed with contact metallization grids that minimize optical losses, resistive losses, and can handle the currents arising form concentrated sunlight, but may also be designed for use in unconcentrated sunlight. PV cell 120 may comprise an integral chip (die) that is sized and shaped to provide the desired active region, or may comprise multiple smaller chips arranged to form the desired active region area and connected according to known techniques. PV cell 120-1 is electrically connected by way of wires or other connectors (not shown) to an external circuit in order to supply power to a load according to known techniques.

Trough-type reflectors 130-1 and 130-2 are fixedly connected along a common edge 135 in a decentered arrangement in which focal lines FL1 and FL2 are parallel and spaced-apart in an overlapping manner such that (first) solar radiation directed onto curved reflective surface 132-1 (indicated by dashed-line arrows B11 and B12) is reflected and concentrated (converged) toward focal line FL1, and (second) solar radiation B21, B22 directed onto curved reflective surface 132-2 is reflected and concentrated toward focal line FL2, and, as shown in the bubble located at the top of Fig. 1, the reflected solar radiation overlaps in a defocused state before striking the active region of PV cell 120. That is, solar radiation beams B11 and B12 are reflected by curved reflective surface 132-1 toward focal line FL1, and would converge at focal line FL1 in the absence of PV cell 120. Similarly, solar radiation beams B21 and B22 are reflected by curved reflective surface 132-2 toward focal line FL2. As indicated in the bubble at the top of Fig. 1, which depicts a side view of PV cell 120 during operation, reflected solar radiation beams B11 and B12 travel in a rightward angled direction, and strike the active (lower) surface of PV cell 120 in a converging (defocused) state such that the reflected radiation is spread over the active surface. Similarly, reflected solar radiation beams B21 and B22 travel in a leftward angled direction, and strike the active surface of PV cell 120 in a converging state, and are directed such that beams B21 and B22 overlap (i.e., cross paths with) beams B11 and B12 while in the defocused state. In this way, decentered reflective surfaces 132-1 and 132-2 combine to form an optical system that concentrates solar radiation in which the reflected light is spread out in a more uniform irradiance distribution on solar cell 120, in comparison to the convention arrangements described above with reference to Figs. 18(A) and 18(B), in order to lower the peak local concentration, which reduces the I²R series resistance associated losses due to smaller current density levels. The optical system formed by curved reflective surfaces 132-1 and 132-2 reduces the peak concentration on solar cell 120 by a factor of approximately 20, relative to the conventional focused system described above with reference to Fig. 18(A), and by a factor of approximately 2.3 relative to the conventional defocused system described above with reference to Fig. 18(B), without requiring a secondary optical element. As described further below, this optical system also produces a substantially more uniform irradiance distribution relative to designs that use a centered surface.

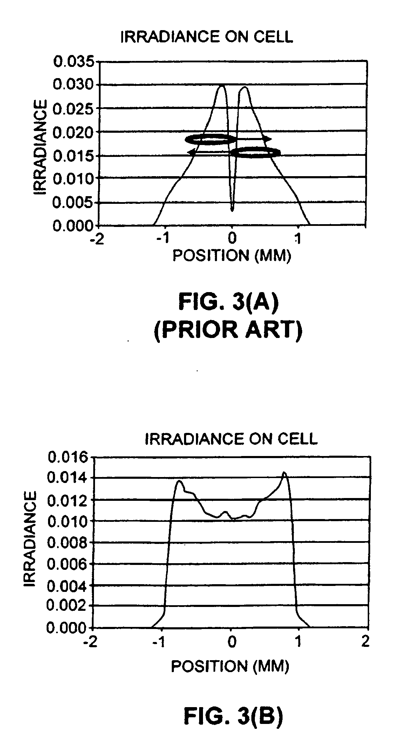

Fig. 2 is a simplified explanatory diagram indicating the formation of the optical system utilized by the present invention in accordance with an embodiment of the present invention. Fig. 2 shows two hypothetical trough-type (e.g., linear parabolic) reflectors 130-11 and 130-12, each having a concave curved reflective surface that reflects light to an associated focal line FL1 or FL2. In particular, the curved reflective surface of hypothetical reflector 130-11 optically defines focal line FL1 such that light directed vertically downward onto reflector 130-11 is reflected and focused into the pie-shaped region bordered by reflector 130-11 and the two dash-dot lines extending from the outside edges of reflector 130-11 to focal line FL1. Similarly, the curved reflective surface of reflector 130-21 defines focal line FL2 such that light directed vertically downward onto reflector 130-21 is focused into the pie-shaped region bordered by reflector 130-21 and the two dash-dot-dot lines extending from the outside edges of reflector 130-21 to focal line FL2. To produce the desired decentered arrangement, hypothetical reflectors 130-11 and 130-21 are overlapped and arranged as shown in Fig. 2 such that focal lines FL1 and FL2 are parallel and spaced apart, and outside portions 130-12 and 130-22 of hypothetical reflectors 130-11 and 130-21 are removed, leaving overlapped sections 130-1 and 130-2, which are described above with reference to Fig. 1, and are optionally secured along edge 135. As indicated by the shaded regions in the center of Fig. 2, decentered sections 130-1 and 130-2 form an optical system that focuses received light at focal lines FL1 and FL2 in a way that creates an overlap region OL through which substantially all of the reflected light passes in a defocused state, wherein the reflected light is spread out in a more uniform irradiance distribution that that associated with conventional optical systems. According to an aspect of the first embodiment, PV cell 120 is positioned in overlap region OL, whereby PV cell 120 receives substantially all of the light reflected by curved reflective surfaces 132-1 and 132-2 in the uniform irradiance distribution pattern. Figs. 3(A) and 3(B) are graphs showing how the irradiance distribution from each reflected surface of a centered parabolic reflector can be spread and shifted relative to each other so that they overlap in a way that reduces the peak concentration and homogenizes or flattens the light distribution on a solar cell. Fig. 3(A) shows the highly peaked irradiance distribution generated by the conventional concentrating solar collector of Fig. 18(B). The decentered parabolic surfaces of the present invention cause the irradiance patterns from each section to spread and overlap, as shown in Fig. 3(B).

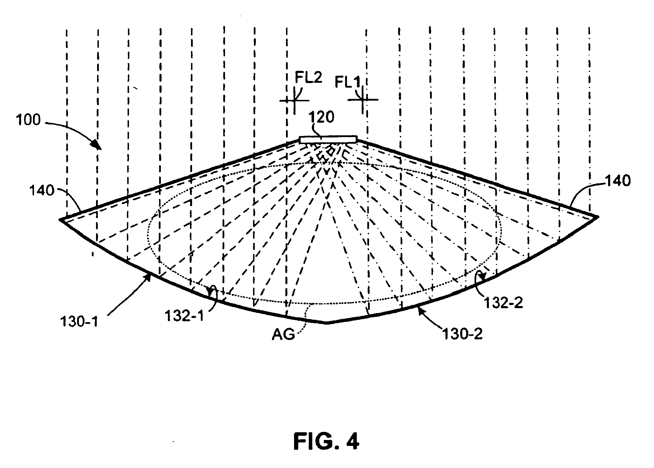

Fig. 4 is a simplified side view showing linear concentrating solar collector 100 when operably exposed to sunlight (indicated by dashed lined arrows). As indicated, PV cell 120 is positioned in the overlap region (described above with reference to Fig. 2) such that PV cell 120 receives substantially all of the light reflected by curved reflective surfaces 132-1 and 132-2. Further, the received light is in a highly uniform irradiance distribution pattern, as described above, thereby lowering the peak local concentration and reducing the I²R series resistance associated losses in PV cell 120 due to smaller current density levels. This arrangement also minimizes the size of solar cell 120 while taking advantage of maximum uniform irradiance provided by the combined overlapping light reflected from curved reflective surfaces 132-1 and 132-2.

According to this comparative example, as indicated in Fig. 4, PV cell 120 is supported over trough-type reflectors 130-1 and 130-2 by rods 140 such that an air gap AG extends between the first and second curved reflective surfaces 132-1 and 132-2 and PV cell 120. Although this embodiment utilizes conventional structures to support PV cell 120, the optical system of the present invention can also be implemented using a solid dielectric optical element, which provides advantages that are set forth with reference to the following embodiments.

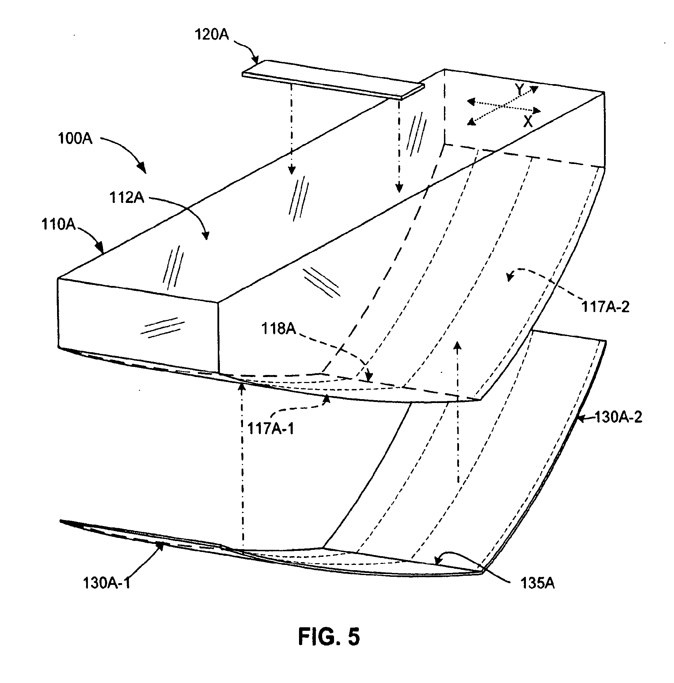

Figs. 5, 6 and 7 show a linear concentrating solar collector 100A according to a first embodiment of the present invention that includes a solid, light-transparent optical structure 110A having a front surface 112A and an opposing rear surface 115A that includes a first reflective surface region 117A-1 and a second reflective surface region 117A-2. Solar collector 100A also includes trough-type reflectors 130-1 and 130A-2 that are respectively disposed on the reflective surface regions 117A-1 and 117A-2 and arranged such that curved reflective surfaces 132A-1 and 132A-2 of reflectors 130A-1 and 130A-2 face (upward) into optical structure 110A, and a PV cell 120A that is mounted on a central region of front surface 112A such that an active region of PV cell 120A faces (downward) into the optical structure 110A.

According to an aspect of the first embodiment, optical structure 110A is a solid, single-piece, light-transparent (e.g., low-iron glass, clear plastic or other clear dielectric solid) structure constructed such that front surface 112A is a substantially flat (planar), and light receiving surface regions 117A-1 and 117A-2 are curved so substantially match the desired shape of reflectors 130A-1 and 130A-2. As used herein the phrase "substantially flat" is intended to mean that parallel light beams pass through any portion of front surface 112A without significant refraction. As indicated by specific embodiments described below, the size of optical structure 110A is expandable in either of the lengthwise (y-axis) direction and the widthwise (x-axis) direction in order to increase solar power generation. In a specific embodiment the optical system design parameters are: geometric concentration of 10, 35 mm aperture, 3.5 mm cell size, and 12.0 mm center thickness. The radius of curvature of the decentered parabolic surfaces is 26 mm, and each parabolic surface is decentered by 1.5 mm. The resulting light distribution on the PV cell underfills the cell, which allows enough latitude for manufacturing tolerances.

As indicated in Figs. 5-7, PV cell 120A is secured to upper surface 112A, e.g., by way of a light transparent adhesive. PV cell 120A is otherwise substantially consistent with the description provided above with reference to Fig. 1.

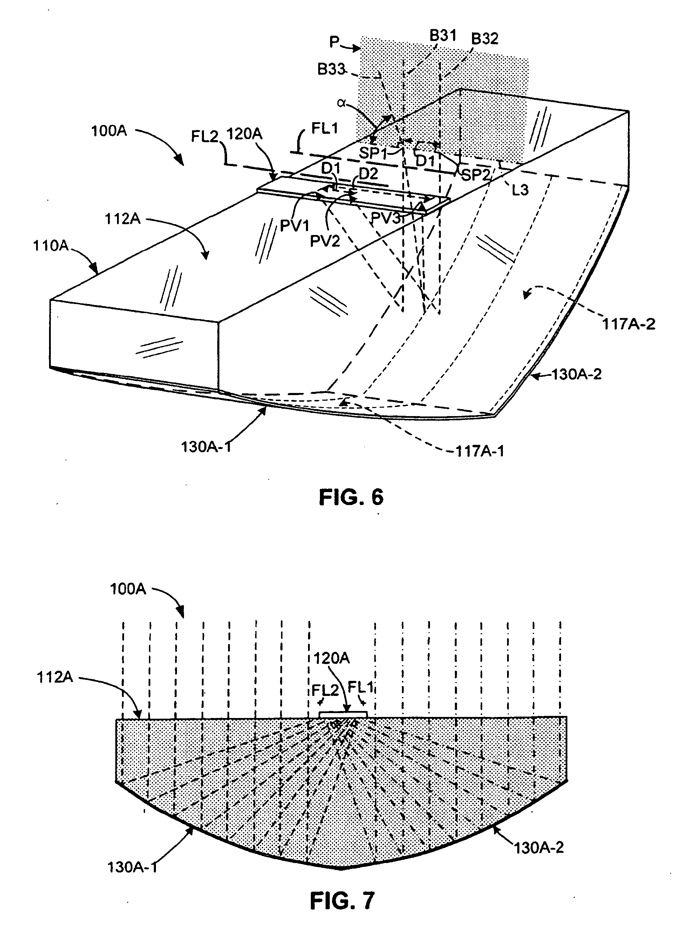

In accordance with a specific embodiment, reflective surface regions 117A-1 and 117A-2 are processed using known techniques to include surface shapes that precisely match the decentered arrangement described above, and trough-like reflectors 130A-1 and 130A-2 are fabricated by sputtering or otherwise depositing a reflective mirror material (e.g., silver (Ag) or aluminum (Al) or high efficiency multilayer dielectric reflective coating) directly onto surface regions 117A-1 and 117A-2. This manufacturing technique minimizes manufacturing costs and providing superior optical characteristics. That is, by sputtering or otherwise forming a mirror film on reflective surface regions 117A-1 and 117A-2 using a known mirror fabrication technique, trough-like reflectors 130A-1 and 130A-2 take the shape of surface regions 117A-1 and 117A-2, and reflect light toward focal lines FL1 and FL2 in the manner described above and shown in Fig. 7. As such, optical structure 110A is molded or otherwise fabricated such that reflective surface regions 117A-1 and 117A-2 are arranged and shaped to produce the desired mirror shapes. Note that, by forming reflective surface regions 117A-1 and 117A-2 with the desired shape and position, trough-like reflectors 130A-1 and 130A-2 are effectively self-forming and self-aligning, thus eliminating expensive assembly and alignment costs associated with conventional concentrating solar collectors. Further, because trough-like reflectors 130A-1 and 130A-2 and PV cell 120A remain affixed to optical structure 110A, their relative position is permanently set, thereby eliminating the need for adjustment or realignment that may be needed in conventional multiple-part arrangements. Further, as indicated in Fig. 6, by utilizing the reflective surface regions of optical structure 110A to fabricate the mirrors, once light enters into optical structure 110A through front surface 112A, the light substantially remains inside optical structure 110A before reaching PV cell 120A. As such, the light is subjected to only one air/glass interface (i.e., at front surface 112A), thereby minimizing losses that are otherwise experienced by conventional multi-part concentrating solar collectors.

According to another aspect of the present embodiment, any sunlight rays directed onto the front surface of the optical element that are in a plane parallel to the focal lines defined by the de-centered reflective surfaces is directed onto the collector's solar cell. For example, referring to Fig. 6, a plane P is parallel to focal lines FL1 and FL2 and intersects front surface 112A along a line L3. "Normal" sunlight beams B31 and B32 are in plane P, and are parallel and spaced apart by a distance D1, and are also perpendicular to front surface 112A. As such, normal beams B31 and B32, which are directed at a 90° (normal) angle to front surface 112A, pass through front surface 112A at surface points SP1 and SP2 that are spaced apart by distance D1, and are reflected by reflector 130A-2 toward focal line FL2, thus striking points PV1 and PV2 on the underside surface of PV cell 120A, where points PB1 and PV2 are also spaced apart by distance D1. In contrast, "non-normal" beam B33, which is also in plane P, an acute angle α relative to front surface 112A, and strikes front surface 112A at surface point SP1. Because beams B33 arrive at angle α, beam B33 is directed onto a different point on reflector 130A-2, but otherwise is reflected by reflector 130A-2 toward focal line FL2 at the same angle as that applied to beams B31 and B32, thus causing beam B33 to strike a point PV3 on the underside surface of PV cell 120A that is spaced from point PV1 by a distance D2, where the distance D2 is determined by angle α. In this way, both normal and non-normal beams are reflected by reflective surfaces 130A-1 and 130A-2 toward focal lines FL1 and FL2, and thus onto PV cell 120A. That is, any incoming beam that lies in a plane parallel to the plane formed by the line focus (or centerline axis of the reflective surface) and front surface normal but is incident on the top surface at less than a 90 degree angle, is still directed onto the line focus at a position further down the line focus. This property makes linear concentrating solar collectors formed in accordance with the present invention especially suited to use with an azimuth rotation tracking based system such as that disclosed in EP-A-2221553 incorporated herein by reference in its entirety. This property results from the fact that all of the surfaces focusing the light in this line focus optical system are reflective and not refractive. A line focus system with refractive power like a cylindrical lens surface or a cylindrical Fresnel lens surface would not have this property.

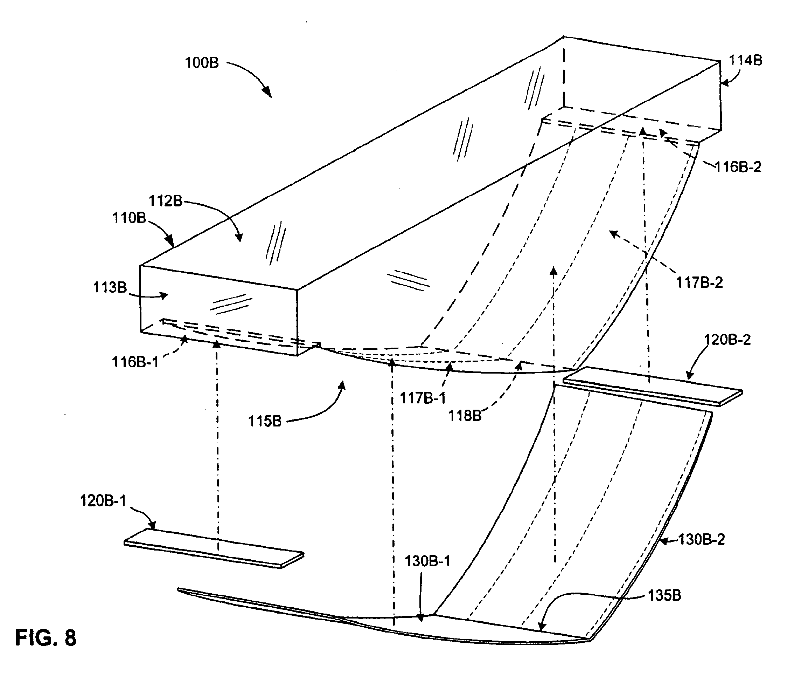

Figs 8-10 show a linear concentrating solar collector 100B according to another specific embodiment of the invention. Similar to the previous embodiment, linear concentrating solar collector 100B includes an optical structure 110B, PV cells 120B-1 and 120B-2, and trough-like reflectors 130B-1 and 130B-2.

Optical structure 110B is solid dielectric (e.g., plastic or glass) structure having a substantially flat front surface 112B and a rear surface 115B that includes planar (flat) receiver surface regions 116D-1 and 116B-2 for receiving PV cells 120B-1 and 120B-2, and curved reflective surface regions 117B-1 and 117B-2 that are disposed between receiver surface regions 11613-1 and 116B-2. Similar to the previous embodiment, curved reflective surface regions 117B-1 and 117B-2 are processed using known techniques to include surface shapes that precisely match the decentered arrangement described below.

PV cells 120B-1 and 120B-2 are substantially the same as the PV cells associated with the previously described embodiments, and are respectively mounted on receiver surface regions 116B-1 and 116B-2 using the methods described above. However, PV cells 120B-1 and 120B-2 differ from the previous embodiment in that the active regions of PV cells 120B-1 and 120B-2 face upward (i.e., toward front surface 112B).

Trough-like reflectors 130B-1 and 130B-2 are also similar to the previous embodiment in that they are deposited (e.g., sputtered) or otherwise coated onto curved reflective surface regions 117B-1 and 117B-2 such the they provide reflective surfaces 132B-1 and 132B-2 that face into optical structure 110B. In an alternative embodiment reflectors 130B-1 and 130B-2 are fabricated on light transparent dielectric films using known techniques, and then laminated (e.g., using an adhesive) or otherwise secured to reflective surface regions 117B-1 and 117B-2. This alternative production method may increase manufacturing costs over the direct mirror formation technique, and may reduce the superior optical characteristics provided by forming mirror films directly onto optical structure 110B, but is some instances may provide a cost advantage.

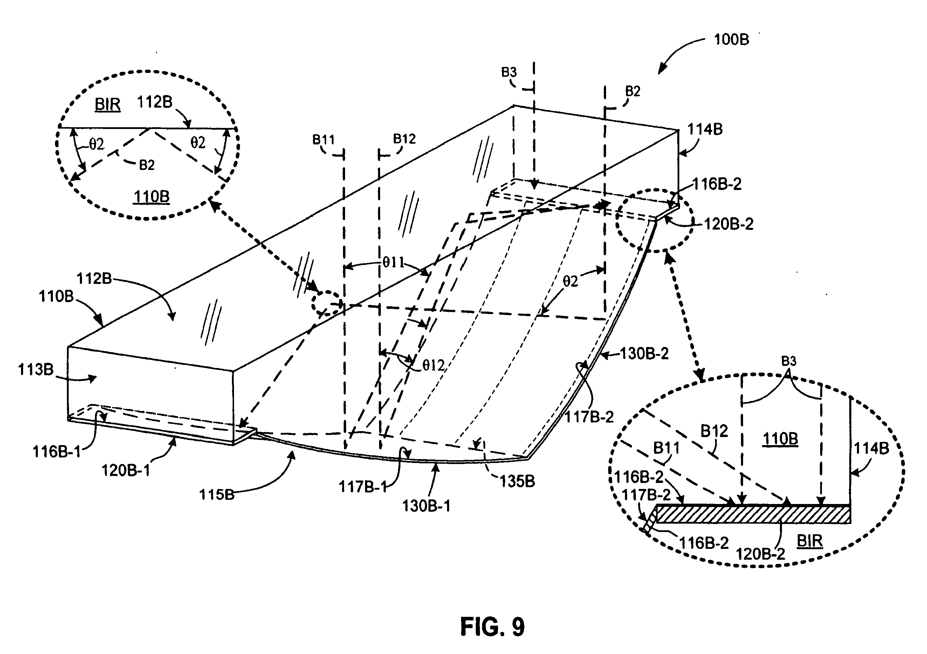

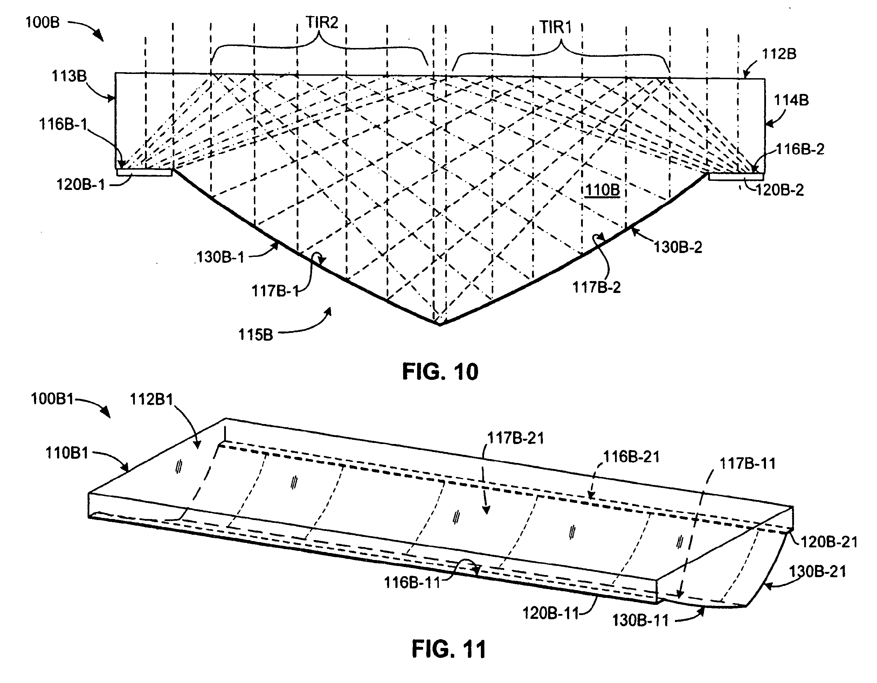

Referring to Figs. 9 and 10, linear concentrating solar collector 100B differs from earlier embodiments in that receiver surfaces regions 116B-1 and 116B-2 (on which solar cells 1208-1 and 120B-2 are mounted) and reflective surface regions 117B-1 and 117B-2 (on which reflectors 1308-1 and 1309-2 are formed) collectively substantially cover the entirety of rear surface 115B of optical structure 110B such that substantially all of the sunlight passing through the front surface 112B either directly strikes one of solar cells 120B-1 and 120B-2, or is reflected and concentrated by decentered reflective surfaces 132B-1 and 132B-2 onto solar cells 120B-1 and 120B-2. The terms "substantially entirely covers" and "substantially all of the sunlight" are intended to mean that the area amount of rear surface 115B that serves neither the reflection nor solar energy receiving functions, such as regions where sunlight is lost due to edge effects and manufacturing imperfections, is minimized (e.g., less than 5%) in order to maximize the amount of sunlight converted into usable power. As set forth in additional detail below, by substantially entirely covering rear surface 115B with PV cells 1208-1 and 120B-2 and reflectors 130B-1 and 130B-2, the present invention provides an advantage over conventional concentrating solar collectors by eliminating shaded regions, thereby facilitating the conversion of substantially all sunlight entering optical structure 110B.

According to another aspect of current embodiment, each reflector 130B-1 and 130B-2 is disposed in a decentered arrangement such that solar radiation is reflected toward front surface 112B at an angle that causes said reflected solar radiation to be re-reflected by total internal reflection (TIR) from front surface 112B onto one of PV cells 120B-1 and 120B-2 (i.e., through an associated one of receiver surface regions 116B-1 and 1168-2) . For example, a sunlight beam B12 entering optical structure 110B through front surface 112B and directed onto reflector 130B-2 is reflected by a reflector 130B-2 at an angle θ2 toward front surface 112B, with angle θ2 being selected such that beam B12 is both subjected to total internal reflection (TIR) when it encounters front surface 112B (e.g., as indicated in the small dashed-line bubble located at the upper left portion of Fig. 9), and is re-reflected from front surface 112B onto PV cell 120B-1 through receiver surface region 116B-1. Similarly, a sunlight beam B11 entering through front surface 112B and directed onto reflector 130B-1 is reflected at an angle θ11 toward front surface 112B such that beam B11 is subjected to TIR and is re-directed onto PV cell 120B-2 through receiver surface region 116B-2 (as indicated in the lower right bubble of Fig. 9). Note that the reflection angle varies along reflectors 130B-1 and 130B-2 to achieve the goals of TIR and re-direction onto a selected PV cell. For example, a sunlight beam B12 entering through front surface 112B and directed onto a second location on reflector 130B-1 is reflected at an angle θ12 toward front surface 112B such that beam B12 is subjected to TIR at a different location on front surface 112D than beam B11, and is re-directed through receiver surface region 116B-2 onto a different region of PV cell 120B-2 (as indicated in the lower right bubble of Fig. 9). The different TIR angles and different reflection points from upper surface 112B are indicated in Fig. 10, wherein sunlight reflected by reflector 130B-1 is subject to TIR in region TIR1 of upper surface 112B, and sunlight reflected by reflector 130B-2 is subject to TIR in region TIR2. The optical efficiency of the resulting system is very high because there is one Fresnel reflection off of front surface 112B, one reflection off of reflector 130B-1 or 130B-2, and one total internal reflection (TIR) off of front surface 112B.

According to another aspect of concentrating solar collectors 100B, sunlight beams passing through front surface 112B that are directed onto one of PV cell 120B-1 and 1208-2, such as beam B3 that is shown in Fig. 1 as being directed onto PV cell 120B-2 (i.e., without reflection), is directly converted to usable power. Because substantially all solar radiation directed into optical structure 110B either directly enters a PV cell or is reflected onto a PV cell, concentrating solar collector 100B facilitates the conversion of substantially all sunlight entering optical structure 110B, thereby providing a highly efficient concentrating solar collector having no shaded or otherwise non-productive regions.

Fig. 11 is a perspective view showing an elongated linear concentrating solar collector 100B1 having an elongated optical structure 110B1 that is formed in accordance with optical structure 110B (described above with reference to Figs. 8-10), but is extended in a longitudinal direction to form elongated linear concentrator. This extension may be achieved by operably connecting multiple shorter sections, by tiling, or by extruding or otherwise molding elongated optical structure 110B1 in a single piece. Note that curved reflector surfaces 117B-11 and 117B-21 extend along the entire length of optical structure 110B1, and reflectors 130B-11 and 130B-21 extend along the entire length of curved reflector surfaces 117B-11 and 1179-21. Similarly, flat receiver surfaces 116B-11 and 116B-21 extend along the entire length of optical structure 110B1 on the outside edge of curved reflector surfaces 117B-11 and 117B-21, and solar cell strings 120B-11 and 120B-21 are mounted along the entire length of receiver surfaces 116B-11 and 116B-21. Elongated linear concentrating solar collector 100B1 operates substantially the same as solar collector 100B, described above. The elongation described with reference to Fig. 11 may be utilized in any of the embodiments described herein.

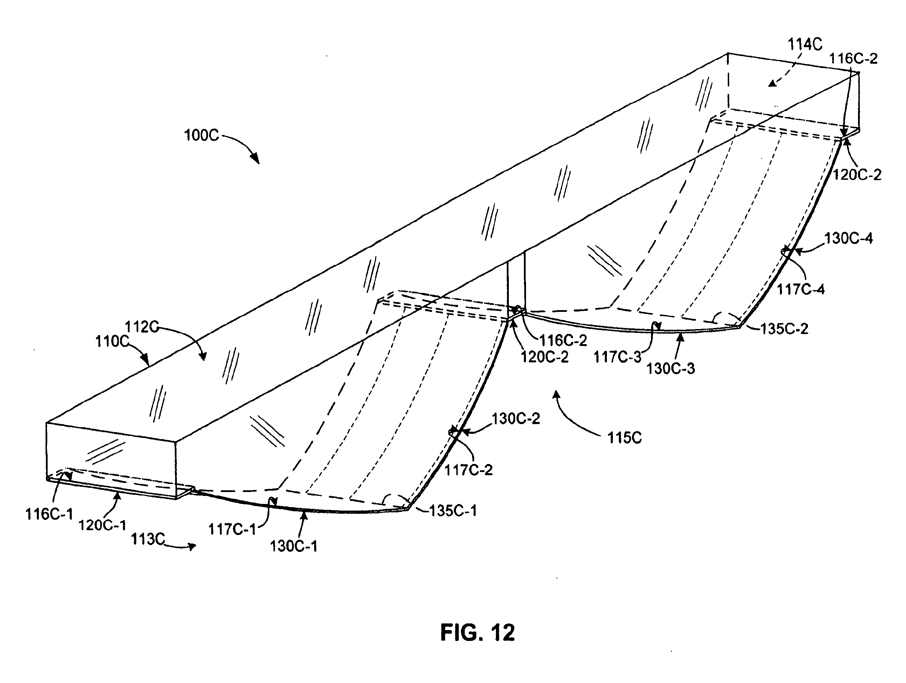

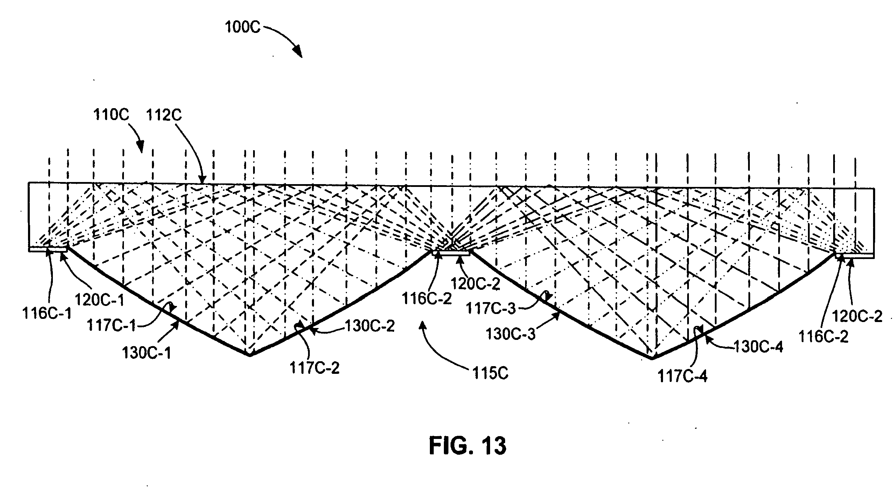

Figs. 12 and 13 show a linear concentrating solar collector 100C according to another specific of the present invention, where solar collector 100C includes a solid optical structure 110C, three solar cells 120C-1, 120C-2 and 120C-3, and four trough-like reflectors 130C-1 to 130C-4. That is, optical structure 110C includes reflective surface regions 117C-1 and 117C-2 and receiver surface regions 116C-1 and 116C-2 that are shaped and arranged in a manner similar to that described above with reference to solar collector 100B, and further includes a third reflective surface region 117C-3 and a fourth reflective surface region 117C-4 , and a third receiver surface region 116C-3 arranged such that reflective surface regions 117C-3 and 117C-4 are disposed between receiver surface region 116C-2 and the receiver surface region 116C-3. Solar cells 120C-1, 120C-2 and 120C-3 are respectively disposed on receiver surface regions 116C-1, 116C-2 and 116C-3, and trough-like reflectors 130C-1 to 130C-4 respectively disposed on reflective surface regions 117C-1 to 117C-4, where reflectors 130C-1 to 130C-4 include reflective surfaces that face upward (i.e., into optical structure 110C). As indicated in Fig. 13, optical structure 110C is arranged such that solar radiation passing through the front surface 112C onto reflective surface region 117C-3 is reflected by reflector 130C-3 toward said front surface at angles that TIR from front surface 112C onto PV cell 120C-3 through said receiver surface region 116C-3, and solar radiation reflected by reflective surface region 117C-4 is directed toward front surface 112C at angles that cause TIR onto PV cell 120C-2 through receiver surface region 116C-2. The three solar cell arrangement allows collection of light over a larger area without making the system thicker. To cover the same area, the two solar cell arrangement would have to be scaled up which includes increasing its thickness. In general, the system can be scaled and/or repeated to increase the collection area of the system. Exemplary optical system design parameters associated with linear concentrating solar collector 100C include: Geometric concentration Cg = 10.5, Cell-to-Cell pitch = 35 mm, maximum element thickness = 14.3 mm, and edge thickness = 5.5 mm.

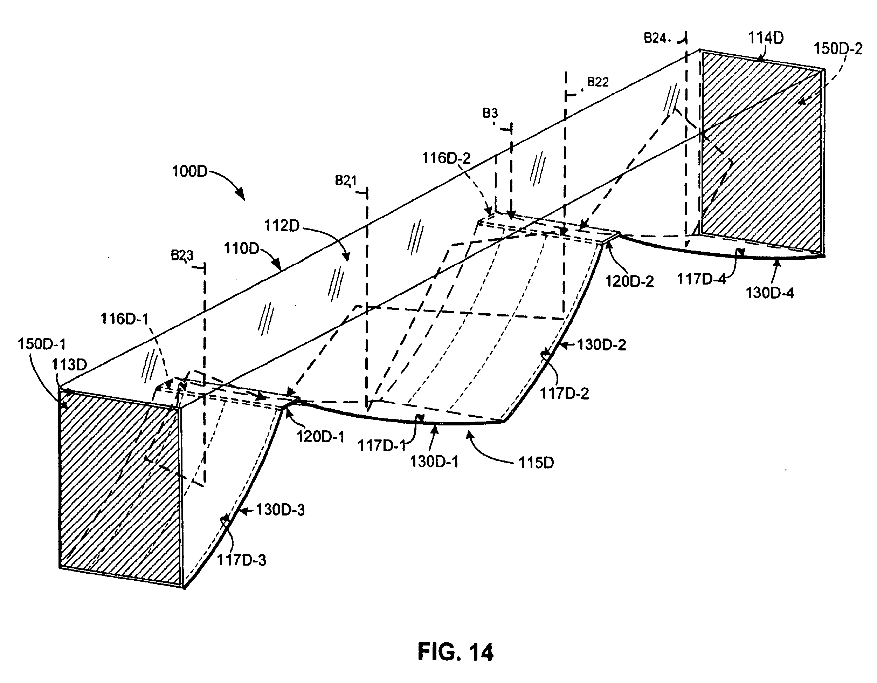

Fig. 14 is an exploded perspective view showing a concentrating solar collector 100D according to another specific embodiment that differs from earlier embodiments in that it includes an extended optical structure 110D having a flat front surface 112D and an opposing rear surface 115D that includes two receiver surface regions 116D-2 and 116D-2 for respectively receiving PV cells 120D-1 and 120D-2 in the manner described above, and four reflective surface regions 117D-1, 117D-2, 117D-3 and 117D-4 that are processed using the methods described above to include four trough-like reflectors 130D-1, 130D-2, 130D-3 and 130D-4.

As indicated by the vertical dashed-line arrows in Fig. 14, reflectors 130D-1 and 130D-2 function similar to the embodiments described above in that received sunlight is reflected by the reflectors against front surface 112D such that the reflected sunlight is re-reflected by TIR onto one of PV cells 120D-1 and 120D-2. For example, reflector 130D-1 is arranged such that sunlight beam B21 is reflected by a region of mirror array 130D-1 and re-reflected by front surface 112D such that it is directed onto PV cell 120D-2, and a second sunlight beam B22 directed onto reflector 130D-2 is reflected and then re-reflected by front surface 112D onto PV cell 120D-1.

Optical structure 110D also differs from the embodiments described above in that it includes a (first) flat, vertical side surface 113D extending between front surface 112D and rear surface rear surface 115D adjacent to reflective surface region 117D-3, and a (second) flat, vertical side surface 114D extending between front surface 112D and rear surface rear surface 115D adjacent to reflective surface region 117D-4. According to the present embodiment, concentrating solar collector 100D further includes a (first) flat side mirror 150D-1 disposed on side surface 113D, and a (second) flat side mirror 150D-2 disposed on side surface 114D, and reflectors 130-3 and 130-4 are arranged to reflect received sunlight such that it is reflected from an associated side mirror 150D-1 or 150D-2 before being re-reflected by TIR from front surface 112D onto one of the PV cells. For example, side mirror 150-1 and reflector 130D-2 are arranged such that sunlight beam B23 passing through the front surface 112D onto reflector 130D-3 is reflected toward side mirror 150D-1 at an angle such that it is re-reflected by side mirror 150D-1 toward front surface 112D, and again re-reflected by TIR from front surface 112D onto PV cell 120-1. Referring to the right side of Fig. 14, side mirror 150-2 and reflector 130-4 are similarly arranged such that sunlight beam B24 is reflected by a reflector 130D-4 toward side mirror 150D-2, from which it is re-reflected toward front surface 112D, and again re-reflected by TIR from front surface 112D onto PV cell 120-2. As in previous embodiments, sunlight passing directly through optical structure 100D to a PV cell is not reflected (e.g., beam B3, which is shown as being directed onto PV cell 120D-2).

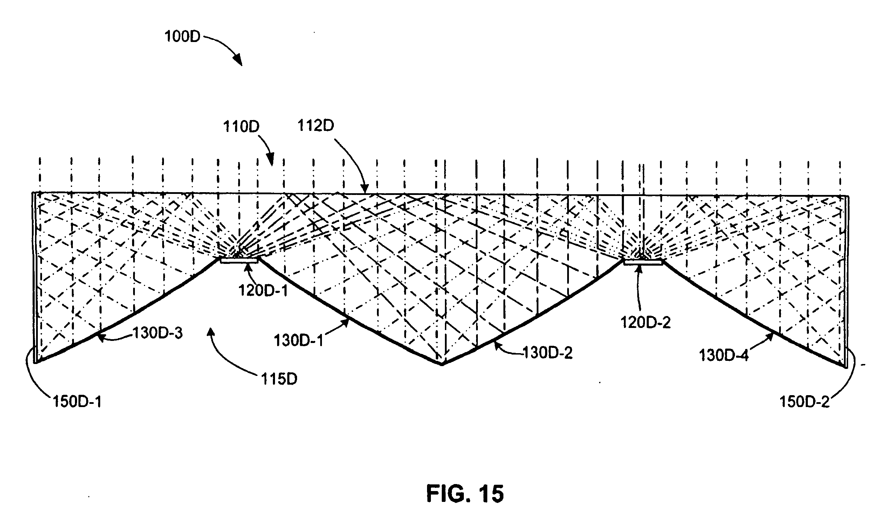

Fig. 15 is a simplified side view diagram showing concentrating solar collector 100D during operation, with the vertical lines disposed above front surface 112D representing incoming sunlight, and the angled lines inside optical structure 110D indicating the reflection pattern of light as it is directed onto one of PV cells 120D-1 and 120D-2 by reflectors 130D-1, 130D-2, 130D-3 and 130D-4 and side mirrors 150D-1 and 150D-2. As indicated in this diagram, the mirror arrangement provided by concentrating solar collector 100D minimizes the loss of light received along the outside edges of optical structure 110D, thus further enhancing efficiency.

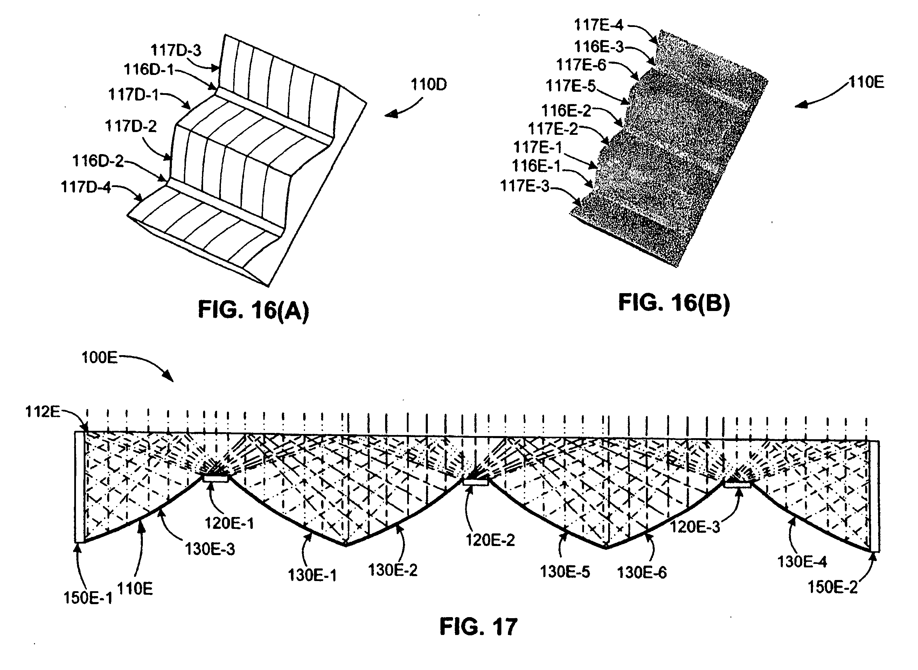

Fig. 16(A) shows optical structure 110D of linear concentrating solar collector 100D by itself to provide a better view of angled light reflecting surface regions 117D-1 to 117D-4, and the position of light receiving surface regions 116D-1 and 116D-2. Note that reflecting surface regions 117D-1 and 117D-2 and light receiving surface regions 116D-1 and 116D-2 form a design unit that can be repeated any number of times in the formation of a linear concentrating solar collector of the present invention. For example, Fig. 16(B) shows optical structure 110E including light reflecting surface regions 117D-1 to 117D-4 and light receiving surface regions 116D-1 and 116D-2, as provided in optical structure 110D, but also includes a second design unit formed by reflecting surface regions 117D-5 and 117D-6 and light receiving surface regions 116D-3 (the second design unit shares light receiving surface regions 116D-2). Fig. 17 is a simplified side view diagram showing a linear concentrating solar collector 100E formed on optical structure 110E during operation, with the vertical lines disposed above front surface 112E representing incoming sunlight, and the angled lines inside optical structure 110E indicating the reflection pattern of light as it is directed onto one of PV cells 120E-1, 120E-2 and 120E-3 by reflectors 130E-1 to 130E-6 and side mirrors 150E-1 and 150E-2.

## Claims

1. A linear concentrating solar collector comprising:
at least one solar energy collection element (120);
a first trough-type reflector (130-1) having a first curved reflective surface defining a first focal line; and
a second trough-type reflector (130-2) having a second reflective surface defining a second focal line,
wherein the first trough-type reflector (130-1) and the second trough-type reflector (130-2) are fixedly connected along a common edge in a decentered arrangement in which the first focal line is parallel to and spaced-apart from the second focal line, and said first and second curved reflective surfaces are arranged such that first solar radiation directed onto said first curved reflective surface is reflected and concentrated by said first curved reflective surfaces toward the first focal line, and second solar radiation directed onto said second curved reflective surface is reflected and concentrated by said second curved reflective surfaces toward the second focal line, said reflected first and second solar radiation is respectively directed by the first and second curved reflective surfaces such that said first and second solar radiation overlap in a defocused state , and
wherein the at least one solar energy collection element (120) is fixedly connected to the first and second trough-type reflectors and positioned to operably receive at least one of the reflected first and second solar radiation, **characterized in that** the collector further comprises a solid, light-transparent optical structure (110A) having a substantially flat front surface and an opposing rear surface (115A), the rear surface including a first reflective surface region (117A-1) and a second reflective surface region (A117A-2),
wherein the first and second trough-type reflectors (130-1, 130-2) are respectively disposed on the first and second reflective surface regions such that the first and second curved reflective surfaces face into the optical structure, wherein the first and second trough-type reflectors preferably comprise one of metal films and high efficiency multilayer dielectric reflective coatings deposited directly onto the first and second reflective surface regions, respectively.

2. The linear concentrating solar collector according to claim 1, wherein the at least one solar energy collection element (120) is positioned in an overlap region between the first and second trough-type reflectors (130-1, 130-2) and the first and second focal lines such that the at least one solar energy collection element receives both said first and second reflected solar radiation in a defocused state.

3. The linear concentrating solar collector according to claim 1 or claim 2,
wherein the at least one solar energy collection element (120) is mounted on a central region of the front surface such that an active region of the at least one solar energy collection element faces into the optical structure, and
wherein the optical structure (110) is arranged such that first solar radiation passing through the front surface onto said first reflective surface region is reflected by said first curved reflective surface onto the at least one solar energy collection element in a defocused state, and such that second solar radiation passing through the front surface onto said second reflective surface region is reflected by said second curved reflective surface onto the at least one solar energy collection element in a defocused state.

4. The linear concentrating solar collector of any of the preceding claims, wherein the rear surface of the optical structure (110) further includes a third reflective surface region and a first receiver surface region arranged such that the first receiver surface region is disposed between the first reflective surface region and the third reflective surface region,
wherein the at least one solar energy collection element (120) is mounted on the first receiver surface region such that an active region of the at least one solar energy collection element faces the front surface,
wherein the optical structure (110) further includes a first side surface extending between the front surface and the rear surface rear surface adjacent to the third reflective surface region, and
wherein the concentrating solar collector further comprises:
a first side mirror disposed on the first side surface; and
a third trough-type reflector disposed on the second reflective surface region,
wherein the first side mirror and the third trough-type reflector are arranged such that solar radiation passing through the front surface onto the third reflective surface region is reflected by the third trough-type reflector toward said first side mirror, and is re-reflected by said first side mirror toward said front surface such that said solar radiation is redirected from said front surface by total internal reflection (TIR) onto said at least one solar energy collection element through said first receiver surface region.

5. The linear concentrating solar collector according to any of the preceding claims, wherein the first and second curved reflective surfaces comprise one of a cylindrical parabolic, conic and aspherical surface.

6. The linear concentrating solar collector according to any of the preceding claims,
wherein the light-transparent optical structure further includes a first receiver surface region and a second receiver surface region disposed on the rear surface on opposite sides of said first and second trough-type reflectors,
wherein the at least one solar energy collection element includes a first solar cell mounted on the first receiver surface region and a second solar cell mounted on the second receiver surface region such that active regions of the first and second solar cells face the front surface, and
wherein the optical structure is arranged such that first solar radiation passing through the front surface onto said first reflective surface region is reflected by said first curved reflective surface toward said front surface at first angles that cause said reflected first solar radiation to be re-reflected by said front surface onto said second solar energy collection element through said second receiver surface region, and such that second solar radiation passing through the front surface onto said second reflective surface region is reflected by said second curved reflective surface toward said front surface at second angles that cause said reflected second solar radiation to be re-reflected by said front surface onto said first solar energy collection element through said first receiver surface region.

7. The linear concentrating solar collector of claim 6, wherein the light-transparent optical structure is arranged such that solar radiation passing through the front surface onto one of said first and second receiver regions passes through said one of said first and second receiver surface regions onto one of said first or second solar energy collection elements.

8. The linear concentrating solar collector of claim 6 or claim 7,
wherein the rear surface of the light-transparent optical structure further includes a third reflective surface region, a fourth reflective surface region, and a third receiver surface region arranged such that the third and fourth reflective surface regions are disposed between the second receiver surface region and the third receiver surface region, and
wherein the linear concentrating solar collector further comprises:
a third solar cell mounted on the third receiver surface region such that an active region of the third solar cell faces the front surface; and
third and fourth trough-type reflectors respectively disposed on the third and fourth reflective surface regions such that third and fourth curved reflective surfaces of the third and fourth trough-type reflectors, respectively, face into the optical structure.

9. The linear concentrating solar collector of claim 8, wherein the optical structure is arranged such that third solar radiation passing through the front surface onto said third reflective surface region is reflected by said third curved reflective surface toward said front surface at third angles that cause said reflected third solar radiation to be re-reflected by said front surface onto said third solar energy collection element through said third receiver surface region, and such that fourth solar radiation passing through the front surface onto said fourth reflective surface region is reflected by said fourth curved reflective surface toward said front surface at fourth angles that cause said reflected fourth solar radiation to be re-reflected by said front surface onto said second solar energy collection element through said second receiver surface region.

10. The linear concentrating solar collector of claim 9,
wherein the optical structure further includes a first side surface extending between the front surface and the rear surface rear surface adjacent to the first reflective surface region, and a second side surface extending between the front surface and the rear surface rear surface adjacent to the fourth reflective surface region, and
wherein the concentrating solar collector further comprises a first side mirror disposed on the first side surface and a second side mirror disposed on the second side surface.

## Patentansprüche

1. Linear konzentrierender Solarkollektor, der umfasst:
wenigstens ein Solarenergie-Kollektorelement (120);
einen ersten Durchgangsreflektor (130-1), der eine erste gekrümmte reflektierende Fläche aufweist, die eine erste Brennlinie definiert; und
einen zweiten Durchgangsreflektor (130-2), der eine zweite reflektierende Fläche aufweist, die eine zweite Brennlinie definiert,
wobei der erste Durchgangsreflektor (130-1) und der zweite Durchgangsreflektor (130-2) entlang einer gemeinsamen Kante in einer dezentrierten Anordnung fest verbunden sind, in der die erste Brennlinie parallel zu der zweiten Brennlinie und von ihr beabstandet ist und die erste sowie die zweite gekrümmte reflektierende Fläche so angeordnet sind, dass erste Solarstrahlung, die auf die erste gekrümmte reflektierende Fläche gerichtet ist, durch die erste gekrümmte reflektierende Fläche reflektiert und zu der ersten Brennlinie hin konzentriert wird, und zweite Solarstrahlung, die auf die zweite gekrümmte reflektierende Fläche gerichtet ist, durch die zweite gekrümmte reflektierende Fläche reflektiert und zu der zweiten Brennlinie hin konzentriert wird, wobei die reflektierte erste und zweite Solarstrahlung durch die erste bzw. die zweite gekrümmte reflektierende Fläche so gerichtet werden, dass sich die erste und die zweite Solarstrahlung in einem defokussierten Zustand überlappen, und
wobei das wenigstens eine Solarenergie-Kollektorelement (120) mit dem ersten und dem zweiten Durchgangsreflektor fest verbunden und so positioniert ist, dass es in Funktion die reflektierte erste oder/und zweite Solarstrahlung empfangen kann, **dadurch gekennzeichnet, dass** der Kollektor des Weiteren eine massive lichtdurchlässige optische Struktur (110A) mit einer im Wesentlichen planen vorderen Fläche und einer gegenüberliegenden hinteren Fläche (115A) umfasst, wobei die hintere Fläche einen ersten reflektierenden Flächenbereich (117A-1) und einen zweiten reflektierenden Flächenbereich (117A-2) enthält,
und der erste sowie der zweite Durchgangsreflektor (130-1, 130-2) an dem ersten bzw. dem zweiten reflektierenden Flächenbereich so angeordnet sind, dass die erste und die zweite gekrümmte reflektierende Fläche in die optische Struktur hinein gerichtet sind, wobei der erste und der zweite Durchgangsreflektor vorzugsweise Metallfilme oder hocheffiziente mehrschichtige dielektrische reflektierende Beschichtungen umfassen, die direkt auf den ersten bzw. den zweiten reflektierenden Flächenbereich aufgebracht sind.

2. Linear konzentrierender Solarkollektor nach Anspruch 1, wobei das wenigstens eine Solarenergie-Kollektorelement (120) in einem Überlappungsbereich zwischen dem ersten und dem zweiten Durchgangsreflektor (130-1, 130-2) sowie der ersten und der zweiten Brennlinie so positioniert sind, dass das wenigstens eine Solarenergie-Kollektorelement sowohl die erste als auch die zweite reflektierte Solarstrahlung in einem defokussierten Zustand empfängt.

3. Linear konzentrierender Solarkollektor nach Anspruch 1 oder Anspruch 2,
wobei das wenigstens eine Solarenergie-Kollektorelement (120) in einem mittleren Bereich der vorderen Fläche so angeordnet ist, dass ein aktiver Bereich des wenigstens einen Solarenergie-Kollektorelementes in die optische Struktur hinein gerichtet ist, und
wobei die optische Struktur (110) so angeordnet ist, dass erste Solarstrahlung, die über die vordere Fläche auf den ersten reflektierenden Flächenbereich gelangt, durch die erste gekrümmte reflektierende Fläche in einem defokussierten Zustand auf das wenigstens eine Solarenergie-Kollektorelement reflektiert wird, und so, dass zweite Solarstrahlung, die über die vordere Fläche auf den zweiten reflektierenden Flächenbereich gelangt, durch die zweite gekrümmte reflektierende Fläche in einem defokussierten Zustand auf das wenigstens eine Solarenergie-Kollektorelement reflektiert wird.

4. Linear konzentrierender Solarkollektor nach einem der vorangehenden Ansprüche, wobei die hintere Fläche der optischen Struktur (110) des Weiteren einen dritten reflektierenden Flächenbereich sowie einen ersten empfangenden Flächenbereich enthält, die so angeordnet sind, dass sich der erste empfangende Flächenbereich zwischen dem ersten reflektierenden Flächenbereich und dem dritten reflektierenden Flächenbereich befindet,
das wenigstens eine Solarenergie-Kollektorelement (120) so an dem ersten empfangenden Flächenbereich angebracht ist, dass ein aktiver Bereich des wenigstens einen Solarenergie-Kollektorelementes der vorderen Fläche zugewandt ist,
die optische Struktur (110) des Weiteren eine erste seitliche Fläche enthält, die sich zwischen der vorderen Fläche und der Rückseite der hinteren Fläche an den dritten reflektierenden Flächenbereich angrenzend erstreckt, und
der konzentrierende Solarkollektor des Weiteren umfasst:
einen ersten seitlichen Spiegel, der sich an der ersten seitlichen Fläche befindet; und
einen dritten Durchgangsreflektor, der sich an dem zweiten reflektierenden Flächenbereich befindet,
wobei der erste seitliche Spiegel und der dritte Durchgangsreflektor so angeordnet sind, dass Solarstrahlung, die über die vordere Fläche auf den dritten reflektierenden Flächenbereich gelangt, durch den dritten Durchgangsreflektor zu dem ersten seitlichen Spiegel hin reflektiert wird und durch den ersten seitlichen Spiegel so zu der vorderen Fläche hin zurückreflektiert wird, dass die Solarstrahlung von der vorderen Fläche durch Totalreflektion (TIR) über den ersten empfangenden Flächenbereich auf das wenigstens eine Solarenergie-Kollektorelement zurück gerichtet wird.

5. Linear konzentrierender Solarkollektor nach einem der vorangehenden Ansprüche, wobei die erste und die zweite gekrümmte reflektierende Fläche eine zylindrischparabolische, konische oder asphärische Fläche umfassen.

6. Linear konzentrierender Solarkollektor nach einem der vorangehenden Ansprüche,
wobei die lichtdurchlässige optische Struktur des Weiteren einen ersten empfangenden Flächenbereich und einen zweiten empfangenden Flächenbereich enthält, die sich an der hinteren Fläche an einander gegenüberliegenden Seiten des ersten und des zweiten Durchgangsreflektors befinden,
wobei das wenigstens eine Solarenergie-Kollektorelement eine erste Solarzelle, die an dem ersten empfangenden Flächenbereich angebracht ist, sowie eine zweite Solarzelle enthält, die an dem zweiten empfangenden Flächenbereich angebracht ist, so dass aktive Bereiche der ersten und der zweiten Solarzelle der vorderen Fläche zugewandt sind, und
wobei die optische Struktur so angeordnet ist, dass erste Solarstrahlung, die über die vordere Fläche auf den ersten reflektierenden Flächenbereich gelangt, durch die erste gekrümmte reflektierende Fläche in ersten Winkeln zu der vorderen Fläche hin reflektiert wird, die bewirken, dass die reflektierte erste Solarstrahlung durch die vordere Fläche über den zweiten empfangenden Flächenbereich auf das zweite Solarenergie-Kollektorelement zurückreflektiert wird, und so, dass zweite Solarstrahlung, die über die vordere Fläche auf den zweiten reflektierenden Flächenbereich gelangt, durch den zweiten gekrümmten Flächenbereich in zweiten Winkeln zu der vorderen Fläche hin reflektiert wird, die bewirken, dass die reflektierte zweite Solarstrahlung über den ersten empfangenden Flächenbereich durch die vordere Fläche auf das erste Solarenergie-Kollektorelement zurückreflektiert wird.

7. Linear konzentrierender Solarkollektor nach Anspruch 6, wobei die lichtdurchlässige optische Struktur so angeordnet ist, dass Solarstrahlung, die über die vordere Fläche auf den ersten oder den zweiten empfangenden Bereich gelangt, über den ersten oder den zweiten empfangenden Flächenbereich auf das erste oder das zweite Solarenergie-Kollektorelement gelangt.

8. Linear konzentrierender Solarkollektor nach Anspruch 6 oder 7,
wobei die hintere Fläche der lichtdurchlässigen optischen Struktur des Weiteren einen dritten reflektierenden Flächenbereich, einen vierten reflektierenden Flächenbereich sowie einen dritten empfangenden Flächenbereich enthält, die so angeordnet sind, dass sich der dritte und der vierte reflektierende Flächenbereich zwischen dem zweiten empfangenden Flächenbereich und dem dritten empfangenden Flächenbereich befinden, und
wobei der linear konzentrierende Solarkollektor des Weiteren umfasst:
eine dritte Solarzelle, die an dem dritten empfangenden Flächenbereich so angebracht ist, dass ein aktiver Bereich der dritten Solarzelle der vorderen Fläche zugewandt ist; und
einen dritten sowie einen vierten Durchgangsreflektor, die an dem dritten bzw. dem vierten reflektierenden Flächenbereich so angeordnet sind, dass die dritte und die vierte gekrümmte reflektierende Fläche des dritten bzw. des vierten Durchgangsreflektors in die optische Struktur hinein gerichtet sind.

9. Linear konzentrierender Solarkollektor nach Anspruch 8, wobei die optische Struktur so angeordnet ist, dass dritte Solarstrahlung, die über die vordere Fläche auf den dritten reflektierenden Flächenbereich gelangt, durch die dritte gekrümmte reflektierende Fläche in dritten Winkeln zu der vorderen Fläche hin reflektiert wird, die bewirken, dass die reflektierte dritte Solarstrahlung über den dritten empfangenden Flächenbereich durch die vordere Fläche auf das dritte Solarenergie-Kollektorelement zurückreflektiert wird, und so, dass vierte Solarstrahlung, die über die vordere Fläche auf den vierten reflektierenden Flächenbereich gelangt, durch die vierte gekrümmte reflektierende Fläche in vierten Winkeln zu der vorderen Fläche hin reflektiert wird, die bewirken, dass die reflektierte vierte Solarstrahlung über den zweiten empfangenden Flächenbereich durch die vordere Fläche auf das zweite Solarenergie-Kollektorelement zurückreflektiert wird.

10. Linear konzentrierender Solarkollektor nach Anspruch 9,
wobei die optische Struktur des Weiteren eine erste seitliche Fläche, die sich zwischen der vorderen Fläche und der Rückseite der hinteren Fläche an den ersten reflektierenden Flächenbereich angrenzend erstreckt, sowie eine zweite seitliche Fläche enthält, die sich zwischen der vorderen Fläche und der Rückseite der hinteren Fläche an den vierten reflektierenden Flächenbereich angrenzend erstreckt, und
wobei der konzentrierende Solarkollektor des Weiteren einen ersten seitlichen Spiegel, der sich an der ersten seitlichen Fläche befindet, sowie einen zweiten seitlichen Spiegel umfasst, der sich an der zweiten seitlichen Fläche befindet.

## Revendications

1. Collecteur solaire à concentration linéaire comprenant :
au moins un élément de collecte d'énergie solaire (120) ;
un premier réflecteur de type auge (130-1) ayant une première surface réfléchissante incurvée définissant une première ligne focale ; et
un deuxième réflecteur de type auge (130-2) ayant une deuxième surface réfléchissante définissant une deuxième ligne focale,
dans lequel le premier réflecteur de type auge (130-1) et le deuxième réflecteur de type auge (130-2) sont reliés de manière fixe le long d'un bord commun dans un agencement décentré dans lequel la première ligne focale est parallèle à la deuxième ligne focale et est espacée de celle-ci, et lesdites première et deuxième surfaces réfléchissantes incurvées sont agencées de sorte qu'un premier rayonnement solaire dirigé sur ladite première surface réfléchissante incurvée soit réfléchi et concentré par lesdites premières surfaces réfléchissantes incurvées vers la première ligne focale, et qu'un deuxième rayonnement solaire dirigé sur ladite deuxième surface réfléchissante incurvée soit réfléchi et concentré par lesdites deuxièmes surfaces réfléchissantes incurvées vers la deuxième ligne focale, lesdits premier et deuxième rayonnements solaires réfléchis sont respectivement dirigés par les première et deuxième surfaces réfléchissantes incurvées de sorte que lesdits premier et deuxième rayonnements solaires se chevauchent dans un état défocalisé, et
dans lequel l'au moins un élément de collecte d'énergie solaire (120) est relié de manière fixe aux premier et deuxième réflecteurs de type auge et positionné pour recevoir de manière fonctionnelle au moins l'un des premier et deuxième rayonnements solaires réfléchis, **caractérisé en ce que** le collecteur comprend en outre une structure optique solide transparente à la lumière (110A) ayant une surface avant essentiellement plate et une surface arrière opposée (115A), la surface arrière comportant une première région de surface réfléchissante (117A-1) et une deuxième région de surface réfléchissante (117A-2) ;
où les premier et deuxième réflecteurs de type auge (130-1, 130-2) sont respectivement disposés sur les première et deuxième régions de surface réfléchissante de sorte que les première et deuxième surfaces réfléchissantes incurvées regardent la structure optique, où les premier et deuxième réflecteurs de type auge comprennent de préférence des films métalliques et/ou des revêtements réfléchissants diélectriques multicouches à haute efficacité déposés directement sur les première et deuxième régions de surface réfléchissante, respectivement.

2. Collecteur solaire à concentration linéaire selon la revendication 1, dans lequel l'au moins un élément de collecte d'énergie solaire (120) est positionné dans une région de chevauchement entre les premier et deuxième réflecteurs de type auge (130-1, 130-2) et les première et deuxième lignes focales de sorte que l'au moins un élément de collecte d'énergie solaire reçoive à la fois lesdits premier et deuxième rayonnements solaires réfléchis dans un état défocalisé.

3. Collecteur solaire à concentration linéaire selon la revendication 1 ou 2,
dans lequel l'au moins un élément de collecte d'énergie solaire (120) est monté sur une région centrale de la surface avant de sorte qu'une région active de l'au moins un élément de collecte d'énergie solaire regarde la structure optique, et
dans lequel la structure optique (110) est agencée de sorte qu'un premier rayonnement solaire traversant la surface avant sur ladite première région de surface réfléchissante soit réfléchi par ladite première surface réfléchissante incurvée sur l'au moins un élément de collecte d'énergie solaire dans un état défocalisé, et de sorte qu'un deuxième rayonnement solaire traversant la surface avant sur ladite deuxième région de surface réfléchissante soit réfléchi par ladite deuxième surface réfléchissante incurvée sur l'au moins un élément de collecte d'énergie solaire dans un état défocalisé.

4. Collecteur solaire à concentration linéaire de l'une des revendications précédentes, dans lequel la surface arrière de la structure optique (110) comporte en outre une troisième région de surface réfléchissante et une première région de surface réceptrice agencées de sorte que la première région de surface réceptrice soit disposée entre la première région de surface réfléchissante et la troisième région de surface réfléchissante,
dans lequel l'au moins un élément de collecte d'énergie solaire (120) est monté sur la première région de surface réceptrice de sorte qu'une région active de l'au moins un élément de collecte d'énergie solaire regarde la surface avant,
dans lequel la structure optique (110) comporte en outre une première surface latérale s'étendant entre la surface avant et la surface arrière de manière adjacente à la troisième région de surface réfléchissante, et
dans lequel le collecteur solaire à concentration comprend en outre :
un premier miroir latéral disposé sur la première surface latérale ; et
un troisième réflecteur de type auge disposé sur la deuxième région de surface réfléchissante,
où le premier miroir latéral et le troisième réflecteur de type auge sont agencés de sorte qu'un rayonnement solaire traversant la surface avant sur la troisième région de surface réfléchissante soit réfléchi par le troisième réflecteur de type auge vers ledit premier miroir latéral, et soit re-réfléchi par ledit premier miroir latéral vers ladite surface avant de sorte que ledit rayonnement solaire soit redirigé à partir de ladite surface avant par réflexion interne totale (TIR) sur ledit au moins un élément de collecte d'énergie solaire à travers ladite première région de surface réceptrice.

5. Collecteur solaire à concentration linéaire selon l'une des revendications précédentes, dans lequel les première et deuxième surfaces réfléchissantes incurvées comprennent l'une d'une surface cylindro-parabolique, d'une surface conique et d'une surface asphérique.

6. Collecteur solaire à concentration linéaire selon l'une des revendications précédentes,
dans lequel la structure optique transparente à la lumière comporte en outre une première région de surface réceptrice et une deuxième région de surface réceptrice disposées sur la surface arrière sur des côtés opposés desdits premier et deuxième réflecteurs de type auge,
dans lequel l'au moins un élément de collecte d'énergie solaire comporte une première cellule solaire montée sur la première région de surface réceptrice et une deuxième cellule solaire montée sur la deuxième région de surface réceptrice de sorte que des régions actives des première et deuxième cellules solaires regardent la surface avant, et
dans lequel la structure optique est agencée de sorte qu'un premier rayonnement solaire traversant la surface avant sur ladite première région de surface réfléchissante soit réfléchi par ladite première surface réfléchissante incurvée vers ladite surface avant à des premiers angles qui amènent ledit premier rayonnement solaire réfléchi à être re-réfléchi par ladite surface avant sur ledit deuxième élément de collecte d'énergie solaire à travers ladite deuxième région de surface réceptrice, et de sorte qu'un deuxième rayonnement solaire traversant la surface avant sur ladite deuxième région de surface réfléchissante soit réfléchi par ladite deuxième surface réfléchissante incurvée vers ladite surface avant à des deuxièmes angles qui amènent ledit deuxième rayonnement solaire réfléchi à être re-réfléchi par ladite surface avant sur ledit premier élément de collecte d'énergie solaire à travers ladite première région de surface réceptrice.

7. Collecteur solaire à concentration linéaire de la revendication 6, dans lequel la structure optique transparente à la lumière est agencée de sorte qu'un rayonnement solaire traversant la surface avant sur l'une desdites première et deuxième régions de surface réceptrice passe à travers ladite l'une desdites première et deuxième régions de surface réceptrice sur l'un desdits premier et deuxième éléments de collecte d'énergie solaire.

8. Collecteur solaire à concentration linéaire de la revendication 6 ou 7,
dans lequel la surface arrière de la structure optique transparente à la lumière comporte en outre une troisième région de surface réfléchissante, une quatrième région de surface réfléchissante, et une troisième région de surface réceptrice agencées de sorte que les troisième et quatrième régions de surface réfléchissante soient disposées entre la deuxième région de surface réceptrice et la troisième région de surface réceptrice, et
dans lequel le collecteur solaire à concentration linéaire comprend en outre :
une troisième cellule solaire montée sur la troisième région de surface réceptrice de sorte qu'une région active de la troisième cellule solaire regarde la surface avant ; et
des troisième et quatrième réflecteurs de type auge disposés respectivement sur les troisième et quatrième régions de surface réfléchissante de sorte que des troisième et quatrième surfaces réfléchissantes incurvées des troisième et quatrième réflecteurs de type auge regardent, respectivement, la structure optique.

9. Collecteur solaire à concentration linéaire de la revendication 8, dans lequel la structure optique est agencée de sorte qu'un troisième rayonnement solaire traversant la surface avant sur ladite troisième région de surface réfléchissante soit réfléchi par ladite troisième surface réfléchissante incurvée vers ladite surface avant à des troisièmes angles qui amènent ledit troisième rayonnement solaire réfléchi à être re-réfléchi par ladite surface avant sur ledit troisième élément de collecte d'énergie solaire à travers ladite troisième région de surface réceptrice, et de sorte qu'un quatrième rayonnement solaire traversant la surface avant sur ladite quatrième région de surface réfléchissante soit réfléchi par ladite quatrième surface réfléchissante incurvée vers ladite surface avant à des quatrièmes angles qui amènent ledit quatrième rayonnement solaire réfléchi à être re-réfléchi par ladite surface avant sur ledit deuxième élément de collecte d'énergie solaire à travers ladite deuxième région de surface réceptrice.

10. Collecteur solaire à concentration linéaire de la revendication 9,
dans lequel la structure optique comporte en outre une première surface latérale s'étendant entre la surface avant et la surface arrière de manière adjacente à la première région de surface réfléchissante, et une deuxième surface latérale s'étendant entre la surface avant et la surface arrière de manière adjacente à la quatrième région de surface réfléchissante, et
dans lequel le collecteur solaire à concentration comprend en outre un premier miroir latéral disposé sur la première surface latérale et un deuxième miroir latéral disposé sur la deuxième surface latérale.
